# EUROPÄISCHE PATENTSCHRIFT

(11) **EP 1 664 881 B1**
(45) Veröffentlichungstag und Bekanntmachung des Hinweises auf die Patenterteilung: **25.02.2009**
(21) Anmeldenummer: 04766720.9
(22) Anmeldetag: 07.09.2004
(51) Int. Cl.: G02B 7/00, G02B 7/02, H04N 5/225, H01L 31/00

(54) **OPTISCHES MODUL MIT BILDSENSOR UND AUF DER SENSITIVEN FLÄCHE DES BILDSENSORS ABGESTÜTZTER LINSENEINHEIT**
OPTICAL MODULE COMPRISING AN IMAGE SENSOR AND A LENS UNIT THAT IS SUPPORTED ON THE SENSITIVE SURFACE OF THE IMAGE SENSOR
MODULE OPTIQUE COMPORTANT UN CAPTEUR D'IMAGE ET UN ENSEMBLE OBJECTIF REPOSANT SUR LA SURFACE SENSIBLE DE CE CAPTEUR D'IMAGE

(30) Priorität: 26.09.2003 DE 10344762
(43) Veröffentlichungstag der Anmeldung: 07.06.2006
(73) Patentinhaber: Continental Automotive GmbH, 30165 Hannover (DE)
(72) Erfinder: FRENZEL, Henryk, 93059 Regensburg (DE); SCHMIDT, Harald, 93055 Regensburg (DE); VOLTZ, Stephan, 91230 Happurg (DE)
(86) Internationale Anmeldenummer: PCT/EP2004/052060
(87) Internationale Veröffentlichungsnummer: WO 2005/031421

(56) Entgegenhaltungen:
- WO-A-03/105465
- PATENT ABSTRACTS OF JAPAN Bd. 2003, Nr. 03, 5. Mai 2003 (2003-05-05) & JP 2002 341218 A (KONICA CORP), 27. November 2002 (2002-11-27)
- PATENT ABSTRACTS OF JAPAN Bd. 2002, Nr. 05, 3. Mai 2002 (2002-05-03) & JP 2002 016826 A (SONY CORP), 18. Januar 2002 (2002-01-18)

## Beschreibung

Die Erfindung betrifft ein optisches Modul mit einem Schaltungsträger, einem auf dem Schaltungsträger angeordneten Halbleiterelement und einer Linseneinheit zum Projizieren von elektromagnetischer Strahlung auf das Halbleiterelement.

Die Erfindung betrifft weiterhin ein optisches System mit einem derartig ausgebildeten optischen Modul.

Gattungsgemäße optische Module und Systeme kommen insbesondere in der Kraftfahrzeugtechnik zum Einsatz.

Dabei kann mit elektromagnetischer Strahlung aus verschiedenen Frequenzbereichen gearbeitet werden, wobei kumulativ zum sichtbaren Licht, mit welchem typischerweise Anwendungen im Außenraum eines Kraftfahrzeuges wie Lane Departure Warning (LDW), Blind Spot Detection (BSD) oder Rear View Cameras arbeiten, insbesondere die für Menschen unsichtbare Infrarotstrahlung bei Anwendungen im Innenraum eines Kraftfahrzeuges wie Out of Position Detection (OOP) oder bei zusätzlichen Außenbeleuchtungen eines Night Vision Systems bevorzugt wird.

Bei Anwendungen im Innen- oder Außenbereich eines Fahrzeugs bestehen hohe Anforderungen aufgrund von äußeren Einflüssen wie Temperatur, Feuchtigkeit, Verschmutzung und Vibration. Die typische Lebensdauer für Systeme im Fahrzeug liegt bei 10 bis 15 Jahren, wobei nur extrem geringe Ausfallraten toleriert werden, so dass auch die Komponenten eines optischen Systems der eingangs genannten Art eine nur sehr langsame Alterung zeigen dürfen.

Da in vielen Fällen der Einbauraum von optischen Modulen bzw. optischen Systemen sehr begrenzt ist, existieren zusätzliche Schwierigkeiten bei der Realisierung der optischen Systeme.
Mit herkömmlichen Mitteln ist es daher extrem schwierig, eine hermetisch abgedichtete zuverlässige Einheit aus einem Kamerachip (CCD- oder CMOS-Sensor) und einer Optik aufzubauen.

Um für ein Kamerasystem, bestehend aus einem Bildsensor (derzeit CCD oder CMOS) und einem Linsensystem ausreichende Bildschärfe zu erreichen, müssen die Komponenten Sensor und Optik geometrisch sehr genau aufeinander abgestimmt werden. Der Toleranzbereich für den Abstand von Kamerachip zu Optik in z-Achse liegt üblicherweise im Bereich von wenigen hundertstel Millimetern um für einen bestimmten Tiefenschärfebereich ein optimal scharfes Bild zu erreichen. Dies ist vor allem für sogenannte Fixfokussysteme problematisch, da diese bei der Fertigung allenfalls gering Toleranz behaftet sein dürfen. Ein Versatz von Kamerachip zu Optik in x- bzw. y-Achse hat zusätzlich zur Folge, dass das optische System unter Umständen "schielt", d.h. an jeweils einer Kante (horizontal oder vertikal) das Bild abgeschnitten wird, da durch den Versatz hier keine Pixel mehr vorhanden sind und vorsorglich bereitgestellt werden müssten.

Ein weiteres Problem stellt der sog. "Tilt" dar, d.h. eine Verkippung des Kamerachips um die x- bzw. y-Achse, was zu Folge hat, dass das Bild einen Unschärfegradienten in horizontaler bzw. vertikaler Richtung aufweist. Daneben kann es noch eine "Rotation" ergeben, d.h. heißt eine Verdrehung um die z-Achse von Kamerachip zu Optik.

Nahezu alle bisher auf den Markt befindlichen Kamerasysteme, die mit einer festen Fokuseinstellung ausgeliefert werden, benötigen während der Fertigung einen zusätzlichen Abgleichungsschritt, bei welchem der Abstand von Kamerachip zu Optik entlang der z-Achse eingestellt und auf diesem Wert fixiert wird. Dies geschieht beispielsweise durch ein Gewinde und eine entsprechende Feststellschraube oder eine Klebeverbindung. Auch für den x-y-Versatz kann ein Abgleichsschritt notwenig sein oder, wenn dieser nicht erfolgt, ein entsprechend größerer Sensor vorgesehen werden, der die Toleranzen durch ein Mehr an Pixel ausgleicht. Es ist auch bekannt, die "Rotation" per Software herauszurechnen bzw. zu kalibrieren. Da ansonsten scharfe Bildinformation vorliegen, müssen die Pixel nur in einer Art "Eichvorgang" neu zugewiesen werden. Allerdings können an den Rändern bzw. Ecken gerade keine Informationen mehr vorliegen, weil diese abgeschnitten sind. Eine rein mechanische Reduzierung schließlich von "Tilt" und "Rotation" zwischen Chip und Optik lässt sich bei üblichen Systemen in der Regel nur durch hochpräzise Fertigung und Montage bzw. durch einen Abgleich der Komponenten erreichen.

Kameras für spezifische Low Cost Anwendungen wie z.B. Automotive, Industrie, Digitalkamera, Handy, Spielzeug etc., sollen jedoch aus Kosten- und Aspekten der Qualitätssicherung möglichst ohne Justagevorgänge zwischen Optik und Kamerachip herstellbar sein, also ohne Einstellungen des Focus auf die optische Fläche des CMOS- oder CCD-Sensors. Dies steht den genannten Anforderungen grundsätzlich entgegen.

Eine Möglichkeit ein fokusfreies System zu entwickeln ist die Summen der möglichen Toleranzen und Elemente zu verkleinern, so dass das Modul bzw. System designbedingt ohne Justage zumindest in einem bestimmten Entfernungs- und Temperaturbereich funktioniert. Bei Verwendung der Erfindung beispielsweise im Rahmen eines Insassenschutzsystems eines Kraftfahrzeuges, auf welches die vorliegende Erfindung jedoch nicht beschränkt ist, sollten scharfe Bilder bei Entfernungen von z.B. 15 cm bis 130 cm sowie bei Temperaturen von z.B. - 40°C bis + 105°C gewährleistbar sein. Dies ist um so eher realisierbar, je weniger Elemente in die Toleranzkette mit eingehen. Einen großen Anteil in der Toleranzkette besitzt der Schaltungsträger für den Kamerachip (derzeit z.B. CCD oder CMOS). So wird insb. bei ungehäusten Chips beispielsweise durch Einsatz von sehr dünnen, sog. flexiblen, Schaltungsträgern versucht, nur eine geringe Dickentoleranz einzubringen. Bei gehäusten Halbleiterelementen besitzen insb. die notwendigen Löt- und ggf. Klebeverbindungen oder dergleichen zwischen Chip und Schaltungsträger einen großen Anteil in der Toleranzkette.

Bei Verwendung von nur einer Linse wird vermieden, dass zusätzliche optische Toleranzen durch einen komplizierten Linsenaufbau bewirkt werden. Der, vorzugsweise aus Kunststoff bestehende, Linsenhalter selbst kann in verschiedener Weise mit der Linsenanordnung verbunden werden, so dass stets eine exakte optische Ausrichtung der Linsenanordnung und des Halbleiterelementes in Bezug auf den Linsenhalter beziehungsweise die Linsenanordnung sichergestellt werden kann.

Dennoch ist bei Systemen, die weitgehend einen klassischen Aufbau aus Objektiv und Kamerachip aufweisen, wobei der Kamerachip bzw. das Halbleiterelement in einem Gehäuse oder auch ungehäust als sog. Flip-Chip oder gebondet auf einem geeigneten Schaltungsträger aufgebracht ist, es schwierig, die genannten Probleme in ihrer Gesamtschau zu umgehen und gleichzeitig die genannten Qualitätsanforderungen zu erfüllen. Zwar sind bei gehäusten Halbleiterchips nur besonderen Maßnahmen gegen Fremdlichtstrahlung oder anderer Umwelteinflüsse von vorne zu ergreifen, da das Chipgehäuse einen ausreichenden Schutz von hinten z.B. für das für IR-Strahlung durchlässige Silizium bietet. Das Objektiv selbst muss jedoch zum Kamerachip justiert sein und eine definierte Fokussierung aufweisen. Dies erfolgt gegenwärtig durch toleranzbehaftete Feststellmöglichkeiten, beispielsweise durch eine Verschraubung, Verklebung oder dergleichen, mittels welcher das Objektiv relativ zum Kamerachip am Schaltungsträger fixiert wird.

In der Druckschrift JP 2002 016826 A wird ein optisches Modul vorgestellt, bei dem der die Linse aufnehmende Linsenhalter durch eine Öffnung in einem Schaltungsträger hindurchgeführt an diesem befestigt ist. Am der Linse gegenüber angeordneten Endstück des Linsenhalters ist ein Bildwandler befestigt. Der Bildwandler ist mithilfe einer an der Außenseite des Linsenhalters angebrachten Leiterstruktur mit weiteren Schaltungselementen auf dem Schaltungsträger elektrisch verbunden. Zur Herstellung einer elektrischen Verbindung mit dem Endstück des Linsenhalters sind auf den Kontaktflächen des Bildwandlers so genannte Bumps angebracht, die nach der Befestigung den Bildwandler in einem fertigungsbedingten Abstand zum Linsenhalter halten, der in einem weiteren Schritt mit einem Hatz versiegelt wird.

In der Druckschrift JP 2002 341218 A wird ein optisches Modul offenbart, bei dem auf einer Schaltplatine ein Bildwandler aufgebracht ist. Zum Projizieren von elektromagnetischer Strahlung auf den lichtsensitiven Abschnitt des als Halbleiterelement ausgebildeten Bildwandlers, ist oberhalb des lichtsensitiven Abschnitts eine Linse oder Linsengruppe angeordnet. Die Linse bzw. Linsengruppe ist in einem Linsenhalter gelagert, der an Schaltplatine im Bereich außerhalb des Halbleiterelements befestigt ist. Die Linse bzw. der Linsengruppe drückt sich über ein elastisches Element vom Innenrand des Linsenhalters ab, wodurch am Rande der Linse ausgebildete Stützelemente gegen die Oberfläche des Halbleiterelements gedrückt werden.

Ausgehend hiervon liegt der Erfindung die Aufgabe zugrunde, ein optisches Modul und ein optisches System mit einem auf einen Schaltungsträger angeordneten Halbleiterelement zur Verfügung zu stellen, bei dem die Toleranzen der verschiedenen Bauteile, insb. zwischen letzter Linsenoberfläche und der Sensoroberfläche, wie z.B. Klebeverbindungen, Linsenhaltertoleranz, Dickentoleranz des Chips oder dergleichen nahezu eliminiert sind, so dass bei einfacher und kostengünstiger Montage eine zuverlässige optische Qualität ohne Justier- und insbesondere Fokussieraufwand zur Verfügung gestellt werden kann und über die Lebensdauer des Moduls bzw. Systems gehalten wird.

Diese Aufgabe wird mit den Merkmalen der unabhängigen Patentansprüche gelöst. Vorteilhafte Ausführungsformen der Erfindung, welche einzeln oder in Kombination miteinander einsetzbar sind, sind in den abhängigen Ansprüchen angegeben.

Die Erfindung baut auf dem gattungsgemäßen optischen Modul dadurch auf, dass die Linseneinheit unmittelbar auf der sensitiven Fläche des Halbleiterelements abgestützt angeordnet ist. Auf diese Weise wird der Toleranzbereich, der für die Fokussierung zur Verfügung steht, möglichst klein gehalten, so dass dieser nur noch Fertigungstoleranzen der Linseneinheit selbst umfasst, indem vorteilhaft die Dickentoleranz des notwendigen Schaltungsträgers und evtl. nötige Klebeverbindungen oder dergleichen durch den erfindungsgemäßen Aufbau vollständig eliminiert sind.

Erfindungsgemäß weist die Linseneinheit einen Linsenhalter auf, welcher auf der sensitiven Fläche des Halbleiterelements abgestützt angeordnet ist, wobei am Linsenhalter wenigstens abschnittsweise ein rahmenförmiger Bereich oder Abstützungen oder dergleichen ausgebildet sind, auf welchem das Halbleiterelement mit seiner optischen Fläche aufliegt. Durch eine direkte Auflage des Chips auf einem, beispielsweise rahmenförmigen, Bereich des Linsenhalters kann in vorteilhafter Weise zum einen der Abstand und damit der Fokusbereich in dem erforderlichen Maße eingehalten werden, zum anderen eine Verkippung der Komponente zueinander auf ein Minimum reduziert werden.

In der Erfindung weist die Linseneinheit eine Stützlinse auf, welche auf der sensitiven Fläche des Halbleiterelements abgestützt angeordnet ist. Dies erfolgt vorzugsweise dergestalt, dass ein Design der Stützlinse gewählt wird, welches auf der dem Chip zugewandten Seite eine im Wesentlichen plane Fläche aufweist, auf welcher der Kamerachip direkt aufliegt.

Zwecks Vermeidung einer Systembeeinträchtigung aufgrund beispielsweise abriebbedingter oder sonstiger Schmutzpartikel zwischen der planen Fläche der Stützlinse und der sensitiven Fläche des Halbleiterelements ist zwischen diesen vorzugsweise ein optisches Gel angeordnet. Die Stützlinse ist dergestalt ausgeführt dass der nötige Abstand zum Kamerasensor durch einen Rahmen oder Abstützungen oder dergleichen realisiert wird, welcher Teil der Linse ist. Dies kann gerade bei der Verwendung von gespritzten Kunststofflinsen einfach realisiert werden, da hier neben der optisch wirksamen Fläche der Linse, gleich ob diese plan oder klassisch gewölbt ausgebildet ist, der Randbereich nahezu beliebig gestaltet werden kann. Wenn der Kamerachip nicht in einem Standardgehäuse sondern beispielsweise in "Flip-Chip" Technik verarbeitet wird, kann diese Abstützung verhältnismäßig einfach erreicht werden, da hier die Chipoberfläche nicht abgedeckt ist und somit zugleich als Referenz dienen kann.

Bei der vorliegenden Erfindung ist vorgesehen, dass das Halbleiterelement auf der der Linseneinheit abgewandten Seite des Schaltungsträgers angeordnet ist, und dass der Schaltungsträger eine Öffnung aufweist, durch die elektromagnetische Strahlung von der Linsenanordnung auf das Halbleiterelement projiziert wird. Das optische Modul ist also in der Reihenfolge Linsenanordnung/Schaltungsträger beziehungsweise flexible Leiterplatte/Halbleiterelement aufgebaut. Auch wenn Ausführungsformen denkbar sind, bei denen die Reihenfolge von Schaltungsträger und Halbleiterelement umgekehrt ist, hat es sich als besonders vorteilhaft erwiesen, den Schaltungsträger mit einer Öffnung zu versehen und so die erstgenannte Reihenfolge zu ermöglichen.

Erfindungsgemäß ist eine Ausgestaltung des rahmenförmigen Bereichs des Linsenhalters oder der Linse dergestalt, dass dieser erstens: mindestens so groß ist, wie die optisch wirksame Fläche des Kamerachips; und zweitens: nur geringfügig kleiner, als das Fenster in dem Substrat (z.B. Flexible Leiterplatte), auf dem der Kamerachip montiert ist. Bei einer derartigen Ausgestaltung kann in vorteilhafter Weise eine Art Selbstzentrierung stattfinden, welche eine exakte Positionierung des Chips zur Optik bezüglich x- und y-Achse gewährleistet und auch den "Tilt" auf ein Minimum reduziert.

Den zunehmenden Miniaturisierungsanforderungen entsprechend ist das Halbleiterelement vorzugsweise als ungehäuster, sog. Flip-Chip auf dem Schaltungsträger angeordnet, da der Flip-Chip bis zu 40 % und somit deutlich weniger Schaltungsträgerfläche im Vergleich zum gehäusten Chip benötigt. Außerdem ist mittels der Flip-Chip-Technologie die wünschenswert geringere Positionstoleranz zwischen dem Sensorchip und dem Schaltungsträger in allen drei Raumrichtungen leichter erreichbar. Die sich auf den Halbleiter-Anschlussflächen befindenden "Kontakthöcker" wie Lötkugeln, Stud Bumps etc. werden durch Löten, Kleben oder Bonden mit dem Schaltungsträger bzw. dem Substrat verbunden. Um ein gegenüber den Umweltanforderungen wie Temperatur, Feuchtigkeit und mechanischen Schock etc. zuverlässiges optisches Modul zu erhalten, ist bekannt, das Halbleiterelement mit einem sogenannten "Underfiller" zu unterfüllen. Damit der Underfiller in den Spalt zwischen Halbleiterelement und Schaltungsträger fließt und den Chip gut unterfüllt, besitzt er eine verhältnismäßig geringe Viskosität und gute Fließeigenschaften. Das hat wiederum den Nachteil, dass aufgrund der engen Platzverhältnisse die sensitive Fläche des Halbleiterelement in den Randbereichen und den Ecken benetzt werden kann, und besagte Bereiche häufig nicht mehr voll funktionsfähig sind. Erfindungsgemäß bevorzugt ist deshalb der rahmenförmige Bereich des Linsenhalters bzw. der Stürzlinse geschlossen ausgebildet, so dass der so ausgebildete, primär der Abstützung dienende, Rahmen zugleich als Fließschutzbarriere für das Underfill-Material fungiert, womit vorteilhaft verhindert ist, dass Underfill-Material, welches zwischen dem Chip und dem Substrat (beispielsweise eine flexible Leiterplatte) gebracht wird, die optisch wirksame Fläche des Halbleiterelements benetzt.

Erfindungsgemäß bevorzugt ist die Linseneinheit bzw. der Linsenhalter mit dem Schaltungsträger abseits der im Schaltungsträger ausgebildeten Öffnung miteinander verbunden, insbesondere verklebt, laserverschweißt, verschraubt und/oder dergleichen mehr, so dass eine Verbindung zwischen Leiterplatte und Linseneinheit beziehungsweise Linsenhalter zur Verfügung gestellt ist, welche die erfindungsgemäße Abstützung der Linseneinheit auf dem Halbleiterelement fixiert und praktisch keine zusätzliche Unsicherheit im Hinblick auf die optische Qualität des Moduls bewirkt.

Die Erfindung besteht weiterhin in einem optischen System mit einem optischen Modul der vorstehend genannten Art. Auf diese Weise kommen die Vorteile des optischen Moduls auch im Rahmen eines Gesamtsystems zur Geltung.

Der Erfindung liegt die Erkenntnis zugrunde, dass durch die Abstützung insb. des Linsenhalters oder der Linse bzw. des Linsenrandbereichs direkt auf der Chipoberfläche ein Kameramodul aufbaubar ist, bei dem auf jegliche mechanische Fokuseinstellung verzichtet werden kann. Somit kann das Modul vollautomatisch gefertigt werden, was bei großen Stückzahlen den Vorteil hat, das die Fertigungs- und Montagekosten geringer werde. Des weiteren kann das optische Modul ohne bewegte Teile wie Gewinde oder Fixierschrauben entwickelt werden, was zu einer höheren Zuverlässigkeit führt. Durch die geringen Toleranzen des Aufbaus auch in x- und y-Achse muss die Chipoberfläche nicht unnötig groß sein, was den Kamerachip billiger macht. Der Aufbau eines solchen Moduls lässt sich sehr kompakt gestalten was den Vorteil hat, dass sich das Kameramodul auch in Anwendungen bei begrenzten Platzverhältnissen einsetzen lässt.

Die Erfindung lässt sich besonders nützlich bei der Realisierung von Videosystemen, ggf. in Kombination mit Radarsystemen, Ultraschallsystemen oder dergleichen im Kraftfahrzeugbereich verwenden.

Die Erfindung wird nun mit Bezug auf die begleitenden Zeichnungen anhand bevorzugter Ausführungsformen beispielhaft erläutert.

Es zeigen schematisch:
- Fig. 1: die Schnittansicht eines ersten Ausführungsbeispiels des erfindungsgemäßen optischen Moduls mit einem Linsenhalter, an welchem ein Rahmen zur Abstützung auf dem Halbleiterelement ausgebildet ist;
- Fig. 2: einen vergrößerten Ausschnitt X des optischen Moduls nach Fig. 1;
- Fig. 3: die Schnittansicht eines zweiten Ausführungsbeispiels des erfindungsgemäßen optischen Moduls mit einer Stützlinse, an welcher Abstützungen zur Abstützung auf dem Halbleiterelement ausgebildet sind;
- Fig. 4: einen vergrößerten Ausschnitt Y des optischen Moduls nach Fig. 3;
- Fig. 5: die Schnittansicht eines alternativen Ausführungsbeispiels des optischen Moduls mit einer Stützlinse, an welcher eine plane Fläche zur Abstützung auf dem Halbleiterelement ausgebildet ist; und
- Fig. 6: die Stützlinse nach Fig. 5 in einer vergrößerten perspektivischen Darstellung.

Bei der nachfolgenden Beschreibung der bevorzugten Ausführungsformen der vorliegenden Erfindung bezeichnen gleiche Bezugszeichen gleiche oder vergleichbare Komponenten.

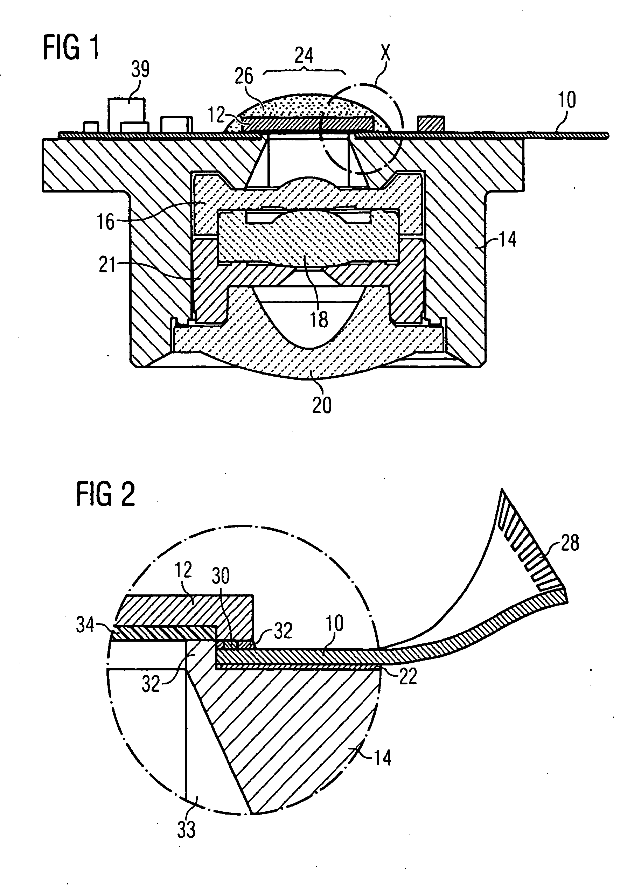

Fig. 1 zeigt die Schnittansicht eines ersten Ausführungsbeispiels des erfindungsgemäßen optischen Moduls mit einer Linseneinheit 14; 16, 18, 20; 21, welche einen Linsenhalter 14 umfasst, an welchem zur Abstützung auf dem Halbleiterelement 12 wenigstens abschnittsweise ein Rahmen 32 ausgebildet ist (vgl. auch Fig. 2). Das Halbleiterelement 12 kann der gegenwärtigen Technologie entsprechend z.B. als CMOS oder CCD ausgelegt sein. Die Verbindung zwischen dem Halbleiterelement 12 und dem Schaltungsträger 10, auf welchem weitere elektronische Bauelemente 39 angeordnet sein können, erfolgt vorzugsweise durch Flip-Chip-Technik, indem eine Lötverbindung über Löt-Bumps 30 hergestellt wird. Weil bei der Flip-Chip-Technologie die sensitiv aktive Fläche 34 dem Substrat 10 zugewandt ist, muss im Schaltungsträger 10 bzw. Substrat eine entsprechende Öffnung 24 vorhanden sein, damit elektromagnetische Strahlung zu der auf elektromagnetische Strahlung empfindlichen Fläche 34 des Halbleiterelements 12 gelangen kann. Zusätzlich oder neben der Lötverbindung 30 kann auch eine Klebeverbindung (nicht dargestellt) vorgesehen sein. Jedenfalls bietet sich an, anschließend die Verbindung mit einem Underfill-Material 31 zu verstärken. Insbesondere in diesen Fällen ist erfindungsgemäß bevorzugt der Rahmen 32 geschlossen auszubilden, so dass dieser 32 zugleich als Fließbarriere wirken und verhindern kann, dass Underfill-Material 31 die optisch wirksame Fläche 34 des Halbleiterelements 12 benetzt. Um das teure Halbleiterelement 12 gegen Umwelteinflüsse zu schützen, wird dessen Abdeckung mit einem Globtop 26 vorgesehen.

Fig. 2 zeigt einen vergrößerten Ausschnitt X des optischen Moduls nach Fig. 1. Insbesondere ist erkennbar, dass der Schaltungsträger 10 als dünner Flex-PCB ausgebildet und mit dem Linsenhalter 14 verklebt ist, beispielsweise über ein dünnes beidseitig klebendes Klebeband 22. An dem entgegengesetzten Ende der Flex-Folie 10 ist diese mit Lötpads 28 versehen, so dass vorzugsweise ohne Bemühung einer weiteren elektrischen Verbindung ein Kontakt zwischen dem optischen Modul und einer (nicht dargestellten) starren Schaltungsplatine, beispielsweise durch Bügellöten unter Verwendung der Lötpads 28 hergestellt werden kann. Alternativ hierzu kann, je nach Ausgestaltung des Schaltungsträgers 10 und/oder Zweckdienlichkeit, eine entsprechende elektrische Verbindung auch durch ein Flachkabel (nicht dargestellt) realisiert sein. Um bei, insbesondere starken, Temperaturschwankungen eine Entlüftung des optischen Moduls zu gestatten, kann beispielsweise in dem Klebestreifen 22 eine Nut (nicht dargestellt)zum Entlüften vorgesehen sein. Ebenfalls ist es möglich, ein Klebe-DAE (Klebe-Druckausgleichselement) auf einer Öffnung (nicht dargestellt) anzuordnen.

In den Linsenhalter 14 nach Fig. 1 ist vorzugsweise eine Linsenanordnung mit mehreren Linsen 16, 18, 20 und ggf. wenigstens einer Blende 21 in Form eines Pakets eingesetzt. Die optische Qualität kann durch ein Objektiv mit mehreren Linsen verbessert werden, was auch im Rahmen der vorliegenden Erfindung möglich ist, insbesondere da mit geringen Toleranzen gearbeitet werden kann. In diesem Zusammenhang ist es auch besonders vorteilhaft, dass die Linsen 16, 18, 20 wie auch die Blende 21 so geformt sind, dass sie relativ zueinander eine definierte Lage innerhalb des Linsenhalters 14 annehmen. Weiterhin ist mindestens eine der Linsen 20 so ausgestaltet, dass sie mit dem Linsenhalter 14 zusammenwirkt und so auch eine definierte Lage bezüglich des Linsenhalters 14 und letztlich aufgrund dessen 14 Abstützung auf dem Halbleiterelement 12 eine definierte Lage zu diesem 12 einnimmt. Auf diese Weise sind alle Linsen 16, 18, 20 und ggf. Blenden 21 bezüglich des Halbleiterelementes 12 justiert. Diese Justierung wird durch weitere Maßnahmen nicht beeinflusst, da der Linsenhalter 14 sich unmittelbar auf dem Halbleiterelement 12 abstützt.

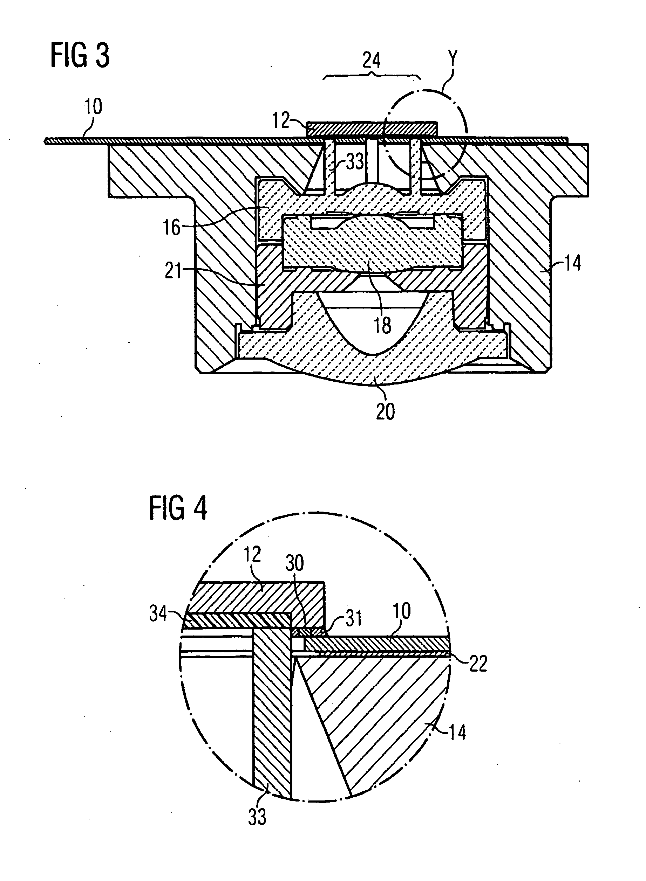

Fig. 3 zeigt die Schnittansicht eines zweiten Ausführungsbeispiels des erfindungsgemäßen optischen Moduls mit einer Stützlinse 16, an welcher Abstützungen 33 zur Abstützung auf dem Halbleiterelement 12 ausgebildet sind. Ebenso kann die Stützlinse 16 so ausgeführt werden, dass der nötige Abstand zum Kamerasensor 12 wenigstens abschnittsweise durch einen Rahmen (nicht dargestellt) oder dergleichen realisiert wird.

Fig. 4 zeigt einen vergrößerten Ausschnitt Y des optischen Moduls nach Fig. 3. Abstützungen 33 bzw. Rahmen sind Teil der Linse 16 und lassen sich insbesondere bei Verwendung kunststoffgespritzter Linsen leicht realisieren, da hier neben der optisch wirksamen Fläche der Linse der Randbereich nahezu beliebig gestaltet werden kann.

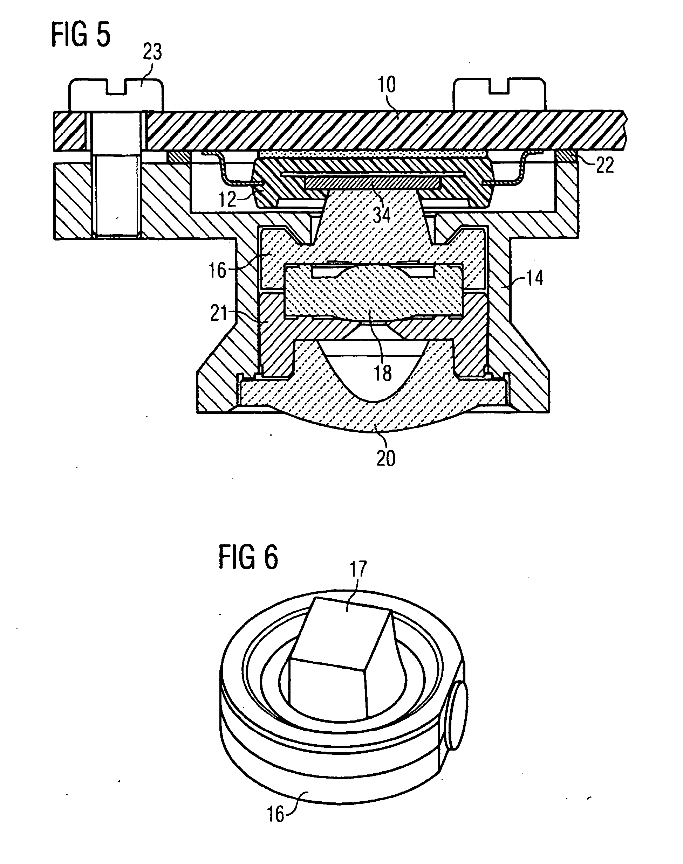

Fig. 5 zeigt die Schnittansicht eines alternativen Ausführungsbeispiels des erfindungsgemäßen optischen Moduls mit einer Stützlinse 16, an welcher eine plane Fläche 17 zur Abstützung auf dem Halbleiterelement 12 ausgebildet ist. In Abweichung zu den vorherigen Darstellungen verdeutlicht die Darstellung in Fig. 5, dass es sich bei dem Halbleiterelement 12 freilich auch um einen gehäusten Chip 12 und bei dem Schaltungsträger um eine starren PCB 10 handeln kann. Die Verbindung zwischen Linseneinheit und Schaltungsträger kann mittels eines Klebebands 22 vorfixiert und mittels Schrauben 23 endfixiert sein.

Fig. 6 schließlich zeigt die Stützlinse 16 nach Fig. 5 mit ihrer plan ausgebildeten Anlagefläche 17 in einer vergrößerten perspektivischen Darstellung.

Die vorliegende Erfindung erlaubt durch die Abstützung des Linsenhalters bzw. der Linse oder des Linsenrandbereichs direkt auf der Chipoberfläche den Aufbau eines Kameramoduls, bei dem auf jegliche mechanische Fokuseinstellung verzichtet werden kann. Somit kann das Modul vollautomatisch gefertigt werden was bei großen Stückzahlen den Vorteil hat, das die Fertigungs- und Montagekosten geringer werde. Des weiteren , kann das Modul ohne bewegte Teile wie Gewinde oder Fixierschrauben entwickelt werden was zu einer höheren Zuverlässigkeit führt. Durch die geringen Toleranzen des Aufbaus auch in x- und y-Achse muss die Chipoberfläche nicht unnötig groß sein, was den Kamerachip billiger macht. Der Aufbau eines solchen Moduls lässt sich sehr kompakt gestalten was den Vorteil hat, dass sich das Kameramodul auch in Anwendungen bei begrenzten Platzverhältnissen einsetzen lässt. Des weiteren bietet der Aufbau die Möglichkeit ein hermetisch abgedichtetes Modul zu entwerfen welches gegen Umwelteinflüsse wie Feuchtigkeit oder Staub gut geschützt ist. Im Falle eines "Flipchip" Aufbaus kann der Rahmen der zur Abstützung dient gleichzeitig als Schutzbarriere für das "Underfill Material" verwendet werden, d.h. verhindern dass das Material, welches zwischen den Chip und dem Substrat (z.B. Flexleiterplatte) gebracht wird, die optische wirksame-Fläche des Chips benetzt.

Die in der vorstehenden Beschreibung, in den Zeichnungen sowie in den Ansprüchen offenbarten Merkmale können sowohl einzeln als auch in beliebiger Kombination auftreten Die Erfindung ist in den beigefügten Ansprüchen definiert. Sie eignet sich insbesondere bei Anwendungen im Innen- und/oder Außenbereich eines Kraftfahrzeugs.

## Patentansprüche

1. Optisches Modul mit
- einem Schaltungsträger (10);
- einem auf dem Schaltungsträger (10) angeordneten Halbleiterelement (12) und
- einer Linseneinheit (14; 16, 18, 20; 21) zum Projizieren von elektromagnetischer Strahlung auf das Halbleiterelement (12),
- wobei die Linseneinheit (14; 16, 18, 20; 21) unmittelbar auf der sensitiven Fläche (34) des Halbleiterelements (12) abgestützt angeordnet ist, indem die Linseneinheit (14; 16, 18, 20; 21) einen Linsenhalter (14) aufweist, welcher auf der sensitiven Fläche (34) des Halbleiterelements (12) abgestützt angeordnet ist und am Linsenhalter (14) wenigstens abschnittsweise ein rahmenförmiger Bereich (32) oder Abstützungen oder dergleichen ausgebildet ist, auf welchem das Halbleiterelement (12) mit seiner optischen Fläche (34) aufliegt;
**dadurch gekennzeichnet,**
- **dass** das Halbleiterelement (12) auf der der Linseneinheit abgewandten Seite des Schaltungsträgers (10) angeordnet ist; und der Schaltungsträger (10) eine Öffnung (24) aufweist, durch die elektromagnetische Strahlung von der Linsenanordnung (16, 18, 20; 21) auf das Halbleiterelement (12) projiziert wird,
- wobei der rahmenförmige Bereich (32) des Linsenhalters (14) so gestaltet ist, dass dieser mindestens so groß ist, wie die sensitive Fläche (34) des Halbleiterelements (12), und geringfügig kleiner, als die im Schaltungsträger (10) ausgebildete Öffnung (24), auf dem das Halbleiterelement (12) montiert ist, so dass eine Selbstzentrierung stattfinden kann.

2. Optisches Modul mit
- einem Schaltungsträger (10);
- einem auf dem Schaltungsträger (10) angeordneten Halbleiterelement (12),
- einer Linseneinheit (14; 16, 18, 20; 21) zum Projizieren von elektromagnetischer Strahlung auf das Halbleiterelement (12),
- wobei die Linseneinheit (14; 16, 18, 20; 21) unmittelbar auf der sensitiven Fläche (34) des Halbleiterelements (12) abgestützt angeordnet ist, indem die Linseneinheit (14; 16, 18, 20; 21) eine Stützlinse (16) aufweist, welche auf der sensitiven Fläche (34) des Halbleiterelements (12) abgestützt angeordnet ist, und wobei an der Stützlinse (16) wenigstens abschnittsweise ein rahmenförmiger Bereich oder Abstützungen (33) oder dergleichen ausgebildet sind, auf welchen das Halbleiterelement (12) mit seiner sensitiven Fläche (34) aufliegt;
**dadurch gekennzeichnet,**
- **dass** das Halbleiterelement (12) auf der der Linseneinheit abgewandten Seite des Schaltungsträgers (10) angeordnet ist; und der Schaltungsträger (10) eine Öffnung (24) aufweist, durch die elektromagnetische Strahlung von der Linsenanordnung (16, 18, 20; 21) auf das Halbleiterelement (12) projiziert wird,
- wobei der rahmenförmige Bereich (32) der Stützlinse (16) so gestaltet ist, dass dieser mindestens so groß ist, wie die sensitive Fläche (34) des Halbleiterelements (12), und geringfügig kleiner, als die im Schaltungsträger (10) ausgebildete Öffnung (24), auf dem das Halbleiterelement (12) montiert ist, so dass eine Selbstzentrierung stattfinden kann.

3. Optisches Modul nach Anspruch 2,
**dadurch gekennzeichnet,**
**dass** die Stützlinse (16) eine plane Fläche (17) aufweist, auf welcher das Halbleiterelement (12) mit seiner sensitiven Fläche (34) aufliegt.

4. optisches Modul nach Anspruch 3,
**dadurch gekennzeichnet,**
**dass** zwischen der planen Fläche (17) der Stützlinse (16) und der sensitiven Fläche (34) des Halbleiterelements (12) ein optisches Gel angeordnet ist.

5. Optisches Modul nach einem der Ansprüche 1 bis 4, wobei das Halbleiterelement (12) als Flip-Chip auf dem Schaltungsträger (10) angeordnet ist,
**dadurch gekennzeichnet,**
**dass** der rahmenförmige Bereich (32) des Linsenhalters (14) bzw. der Stützlinse (16) geschlossen ausgebildet ist, so dass der so ausgebildete Rahmen (32) zugleich als Fließbarriere gegenüber einem Underfill-Material (31) fungiert, das während der Anordnung des Halbleiterelements (12) auf dem Schaltungsträger (10) zwischen diesen (12; 10) gebracht wird.

6. Optisches Modul nach einem der vorherigen Ansprüche,
**dadurch gekennzeichnet,**
**dass** die Linseneinheit (14; 16, 18, 20; 21) bzw. der Linsenhalter (14) mit dem Schaltungsträger (10) abseits der in diesem (10) ausgebildeten Öffnung (24) miteinander verbunden ist, insbesondere verklebt, laserverschweißt, verschraubt und/oder dergleichen mehr.

7. Optisches System mit einem optischen Modul nach einem der vorherigen Ansprüche.

## Claims

1. Optical module with
- a circuit carrier (10);
- a semiconductor element (12) arranged on the circuit carrier (10); and
- a lens unit (14; 16, 18, 20; 21) for projecting electromagnetic radiation onto the semiconductor element (12),
- with the lens unit (14; 16, 18, 20; 21) being arranged supported directly on the sensitive surface (34) of the semiconductor element (12), by the lens unit (14; 16, 18, 20; 21) having a lens holder (14), which is arranged supported on the sensitive surface (34) of the semiconductor element (12) and a frame-shaped area (32) or supports or such like are embodied on the lens holder (14) at least in sections, on which the semiconductor element (12) rests with its optical surface (34);
**characterised in that**,
- the semiconductor element (12) is arranged on the opposite side of the circuit carrier (10) to the lens unit; and the circuit carrier (10) features an opening (24), through which electromagnetic radiation is projected by the lens arrangement (16, 18, 20; 21) onto the semiconductor element (12),
with the frame-shaped area (32) of the lens holder (14) being designed so that this is at least as large as the sensitive surface (34) of the semiconductor element (12), and is slightly smaller than the opening (24) embodied in the circuit carrier (10) on which the semiconductor element (12) is mounted so that a self-centring can take place.

2. Optical module with
- a circuit carrier (10);
- a semiconductor element (12) arranged on the circuit carrier (10);
- a lens unit (14; 16, 18, 20; 21) for projecting electromagnetic radiation onto the semiconductor element (12),
- with the lens unit (14; 16, 18, 20; 21) being arranged supported directly on the sensitive surface (34) of the semiconductor element (12), by the lens unit (14; 16, 18, 20; 21) having a support lens (16), which is arranged supported on the sensitive surface (34) of the semiconductor element (12) and with a frame-shaped area or supports (33) or such like being embodied on the support lens (16) at least in sections, on which the semiconductor element (12) rests with its sensitive surface (34);
**characterised in that**
- the semiconductor element (12) is arranged on the opposite side of the circuit carrier (10) to the lens unit; and the circuit carrier (10) features an opening (24), through which electromagnetic radiation is projected by the lens arrangement (16, 18, 20; 21) onto the semiconductor element (12),
- with the frame-shaped area (32) of the support lens (16) being designed so that this is at least as large as the sensitive surface (34) of the semiconductor element (12); and is slightly smaller than the opening (24) embodied in the circuit carrier (10) on which the semiconductor element (12) is mounted so that a self-centring can take place.

3. Optical module in accordance with claim 2,
**characterised in that**,
the support lens (16) features a flat surface (17) on which the semiconductor element (12) rests with its sensitive surface (34).

4. Optical module in accordance with claim 3,
**characterised in that**,
an optical gel is arranged between the flat surface (17) of the support lens (16) and the sensitive surface (34) of the semiconductor element (12).

5. Optical module in accordance with one of the claims 1 to 4, with the semiconductor element (12) being arranged as a flip chip on the circuit carrier (10),
**characterised in that**,
the frame-shaped area (32) of the lens holder (14) or the support lens (16) is embodied enclosed, so that the frame (32) thus embodied functions at the same time as a flow barrier against an underfill material (31) which is introduced between these two (12; 10) during the arrangement of the semiconductor element (12) on the circuit carrier (10).

6. Optical module in accordance with one of the previous claims,
**characterised in that**,
the lens unit (14; 16, 18, 20; 21) or the lens holder (14) are connected to the circuit carrier (10) away from the opening (24) embodied in this (10), especially glued, laser-welded, screwed and/or in other similar ways.

7. Optical system with an optical module in accordance with one of the previous claims.

## Revendications

1. Module optique comprenant
- un support de circuit (10) ;
- un élément semi-conducteur (12) disposé contre le support de circuit (10) et
- une unité lentille (14 ; 16, 18, 20 ; 21) destinée à projeter un rayonnement électromagnétique sur l'élément semi-conducteur (12) ;
- l'unité lentille (14 ; 16, 18, 20 ; 21) étant disposée directement sur la surface sensible (34) de l'élément semi-conducteur (12), par le fait que l'unité lentille (14 ; 16, 18, 20 ; 21) présente une monture de lentille (14) qui est disposée appuyée contre la surface sensible (34) de l'élément semi-conducteur (12) et que, sur la monture de lentille (14) est formée une région en forme de cadre (32), au moins sous forme de segments, ou des étais ou équivalents, contre lesquels l'élément semi-conducteur (12) repose par sa surface sensible (34),
**caractérisé en ce que**
- l'élément semi-conducteur (12) est disposé contre le côté du support de circuit (10) qui est éloigné de l'unité lentille ; et le support de circuit (10) présente une ouverture (24), à travers laquelle un rayonnement électromagnétique est projeté sur l'élément semi-conducteur (12) par le dispositif à lentille (16, 18, 20 ; 21),
- la région en forme de cadre (32) de la monture de lentille (14) est conformée de sorte qu'elle est au moins aussi grande que la surface sensible (34) de l'élément semi-conducteur (12) et légèrement plus petite que l'ouverture (24) formée dans le support de circuit (10) contre lequel l'élément semi-conducteur (12) est monté, de sorte qu' un auto-centrage peut se produire.

2. Module optique comprenant
- un support de circuit (10) ;
- un élément semi-conducteur (12) disposé contre le support de circuit (10) et
- une unité lentille (14 ; 16, 18, 20 ; 21) destinée à projeter un rayonnement électromagnétique sur l'élément semi-conducteur (12) ;
- l'unité lentille (14 ; 16, 18, 20 ; 21) étant disposée directement sur la surface sensible (34) de l'élément semi-conducteur (12), par le fait que l'unité lentille (14 ; 16, 18, 20 ; 21) présente une lentille de support (16) qui est disposée appuyée contre la surface sensible (34) de l'élément semi-conducteur (12) et que, sur la lentille de support (16) est formée, au moins sous forme de segments, une région en forme de cadre, ou des étais (33) ou équivalents, contre lesquels l'élément semi-conducteur (12) repose par sa surface sensible (34),
**caractérisé en ce que**
- l'élément semi-conducteur (12) est disposé contre le côté du support de circuit (10) qui est éloigné de l'unité lentille ; et le support de circuit (10) présente une ouverture (24) à travers laquelle un rayonnement électromagnétique est projeté sur l'élément semi-conducteur (12) par le dispositif à lentille (16, 18, 20 ; 21),
- la région en forme de cadre (32) de la lentille de support (16) est conformée de sorte qu'elle est au moins aussi grande que la surface sensible (34) de l'élément semi-conducteur (12) et légèrement plus petite que l'ouverture (24) formée dans le support de circuit (10), contre lequel l'élément semi-conducteur (12) est monté, de sorte qu'un auto-centrage peut se produire.

3. Module optique selon la revendication 2,
**caractérisé en ce que** la lentille de support (16) présente une surface plane (17) contre laquelle l'élément semi-conducteur (12) repose par sa surface sensible (34).

4. Module optique selon la revendication 3,
**caractérisée en ce qu'**un gel optique est disposé entre la surface plane (17) de la lentille de support (16) et la surface sensible (34) de l'élément semi-conducteur (12).

5. Module optique selon l'une quelconque des revendications 1 à 4, dans lequel l'élément semi-conducteur (12) est disposé en Flip-Chip contre le support de circuit (10), **caractérisé en ce que** la région en forme de cadre (32) de la monture de lentille (14) ou de la lentille de support (16) est de configuration fermée, de sorte que le cadre (32) ainsi formé joue en même temps le rôle de retenue d'écoulement pour une matière de comblement (31) qui, lors de la pose de l'élément à semi-conducteur (12) sur le support de circuit (10), est mise en place entre ces éléments (12 ; 10).

6. Module optique selon l'une quelconque des revendications précédentes, **caractérisé en ce que** l'unité lentille (14 ; 16, 18, 20 ; 21) ou la monture de lentille (14) est assemblée, en particulier collée, soudée au laser, vissée et/ou équivalent, au support de circuit (10), en dehors de l'ouverture (24) formée dans ce support (10).

7. Système optique possédant un module optique selon l'une quelconque des revendications précédentes.
